# EUROPÄISCHE PATENTSCHRIFT

(11) **EP 2 313 938 B1**
(45) Veröffentlichungstag und Bekanntmachung des Hinweises auf die Patenterteilung: **02.10.2013**
(21) Anmeldenummer: 09781695.3
(22) Anmeldetag: 11.08.2009
(51) Int. Cl.: H01L 35/32, F01N 5/02

(54) **THERMOELEKTRISCHE VORRICHTUNG**
THERMOELECTRIC DEVICE
DISPOSITIF THERMOÉLECTRIQUE

(30) Priorität: 13.08.2008 DE 102008038985
(43) Veröffentlichungstag der Anmeldung: 27.04.2011
(73) Patentinhaber: Emitec Gesellschaft für Emissionstechnologie mbH, 53797 Lohmar (DE)
(72) Erfinder: LIMBECK, Sigrid, 53804 Much (DE); BRÜCK, Rolf, 51429 Bergisch Gladbach (DE)
(74) Vertreter: Rössler, Matthias
(86) Internationale Anmeldenummer: PCT/EP2009/060371
(87) Internationale Veröffentlichungsnummer: WO 2010/018162

(56) Entgegenhaltungen:
- WO-A2-2005/109535
- DE-A1-102005 005 077
- DE-A1-102006 037 540
- DE-A1-102006 039 024
- JP-A- 11 055 973
- JP-A- 2008 035 595
- US-A- 3 035 109
- US-A- 3 240 628
- US-A1- 2006 157 102

## Beschreibung

Die vorliegende Erfindung betrifft eine Vorrichtung zur Erzeugung elektrischer Energie z. B. aus dem Abgas einer Verbrennungskraftmaschine mittels eines Generators. Damit ist insbesondere ein Generator zur Umwandlung thermischer Energie eines Abgases in elektrische Energie gemeint, also ein so genannter thermoelektrischer Generator.

Das Abgas aus einem Motor eines Kraftfahrzeugs besitzt thermische Energie, welche mittels eines thermoelektrischen Generators bzw. Apparates in elektrische Energie umgewandelt werden kann, um beispielsweise eine Batterie oder einen anderen Energiespeicher zu füllen oder elektrischen Verbrauchern die benötigte Energie direkt zuzuführen. Damit steht für den Betrieb des Kraftfahrzeugs Energie in größerem Umfang zur Verfügung.

Ein solcher thermoelektrischer Generator weist zumindest eine Mehrzahl thermoelektrischer Wandlerelemente auf. Thermoelektrische Materialien sind von einer Art, dass diese effektiv thermische Energie in elektrische Energie umwandeln können (Seebeck-Effekt) und umgekehrt (Peltier-Effekt). Der "Seebeck-Effekt" basiert auf dem Phänomen der Umwandlung von Wärmeenergie in elektrische Energie und wird zur Erzeugung thermoelektrischer Energie genutzt. Der "Peltier-Effekt" ist die Umkehrung des Seebeck-Effektes und ein Phänomen, welches mit Wärmeadsorption einhergeht und in Relation zu einem Stromfluss durch unterschiedliche Materialien verursacht wird. Der Peltier-Effekt ist beispielsweise zum thermoelektrischen Kühlen bereits vorgeschlagen worden.

Solche thermoelektrischen Wandlerelemente weisen bevorzugt eine Vielzahl von thermoelektrischen Elementen auf, die zwischen einer so genannten "Warmseite" und einer so genannten "Kaltseite" positioniert sind. Thermoelektrische Elemente umfassen z. B. wenigstens zwei Halbleiterquader (p- und n-dotiert), die auf ihrer Oberseite und Unterseite (hin zur "Warmseite" bzw. "Kaltseite") wechselseitig mit elektrisch leitenden Brücken verbunden sind. Keramikplatten bzw. Keramikbeschichtungen und/oder ähnliche Materialien dienen zur Isolierung der Metallbrücken und sind somit bevorzugt zwischen den Metallbrücken angeordnet. Wird ein Temperaturgefälle beidseits der Halbleiterquader bereitgestellt, so bildet sich Spannungspotential aus. Auf der einen Kontaktstelle wird dabei Wärme aufgenommen ("Warmseite"), wobei die Elektronen der einen Seite auf das energetische höher liegende Leitungsband des folgenden Quaders gelangen. Auf der anderen Seite können die Elektronen nun Energie freisetzen, um wieder auf die andere Seite mit niedrigerem Energieniveau zu gelangen ("Kaltseite"). Somit kann sich bei einem entsprechenden Temperaturgefälle ein Stromfluss einstellen.

Es ist bereits versucht worden, entsprechende thermoelektrische Generatoren für die Anwendung in Kraftfahrzeugen, insbesondere Personenkraftfahrzeugen, bereitzustellen, siehe zum Beispiel DE 10 2005 005 077 A1. Diese waren jedoch meist sehr teuer in der Herstellung und gekennzeichnet durch einen relativ geringen Wirkungsgrad. Damit konnte noch keine Serientauglichkeit erlangt werden. Außerdem konnte festgestellt werden, dass die bekannten thermoelektrischen Generatoren meist sehr großen Bauraum verlangen und deshalb nur schwer in die bestehenden Abgasanlagen integriert werden können.

Hiervon ausgehend ist es Aufgabe der vorliegenden Erfindung, die mit Bezug auf den Stand der Technik geschilderten Probleme zumindest teilweise zu lösen. Insbesondere solle eine thermoelektrische Vorrichtung angegeben werden, die einen verbesserten Wirkungsgrad hinsichtlich der Umwandlung von bereitgestellter thermischer Energie in elektrische Energie ermöglicht, den wechselnden Beanspruchungen im Abgassystem mobiler Verbrennungskraftmaschinen gewachsen ist und sehr kompakt aufgebaut ist.

Diese Aufgaben werden gelöst mit einer Vorrichtung gemäß den Merkmalen des Patentanspruchs 1. Vorteilhafte Ausgestaltungen der erfindungsgemäßen Vorrichtung sowie die Integration dieser Vorrichtung in übergeordnete Baueinheiten sind in den abhängig formulierten Patentansprüchen angegeben. Es ist darauf hinzuweisen, dass die in den Patentansprüchen einzeln aufgeführten Merkmale in beliebiger, technologisch sinnvoller, Weise miteinander kombiniert werden können und weitere Ausgestaltungen der Erfindung aufzeigen. Die Beschreibung, insbesondere im Zusammenhang mit den Figuren, erläutert die Erfindung weiter und führt ergänzende Ausführungsbeispiele der Erfindung an.

Die erfindungsgemäße thermoelektrische Vorrichtung weist zumindest Folgendes auf:
- eine erste Metallfolie mit einer ersten Materialdicke,
- eine zweite Metallfolie mit einer zweiten Materialdicke,
- einen Zwischenraum zwischen der ersten Metallfolie und der zweiten Metallfolie,
- eine elektrische Isolationsbeschichtung auf der ersten Metallfolie und der zweiten Metallfolie hin zum Zwischenraum,
- eine Vielzahl von ersten Halbleiterteilchen und zweiten Halbleiterteilchen, die im Zwischenraum auf der Isolationsbeschichtung fixiert und miteinander elektrisch verbunden sind.

Mit der hier vorgeschlagenen thermoelektrischen Vorrichtung ist insbesondere ein lagenweises bzw. schichtartiges Modul für einen thermoelektrischen Apparat bzw. einen thermoelektrischen Generator angegeben. Dabei sind die Halbleiterteilchen zwischen zwei Metallfolien angeordnet. Der Begriff "Metallfolie" soll dabei insbesondere zum Ausdruck bringen, dass hier eine sehr dünne metallische Wandung für die thermoelektrische Vorrichtung vorgesehen ist, so dass der Wärmeübergang bzw. die Wärmeeinleitung hin zu den Halbleiterteilchen besonders günstig ist. Zudem baut die thermoelektrische Vorrichtung sehr dünn bzw. sehr flach, so dass auch hier besonders begrenzte Räume zur Integration in ein Kraftfahrzeug genutzt werden können. Gegebenenfalls können die erste Metallfolie und die zweite Metallfolie unterschiedliche Funktionen erfüllen, so dass beispielsweise die erste Metallfolie die so genannte "Warmseite" ausbildet und demnach hochtemperaturbeständig sein sollte. Im Gegensatz dazu könnte die zweite Metallfolie die "Kaltseite" bilden, wobei diese beispielsweise auch formstabiler sein könnte (also eine größere zweite Materialdicke aufweisen), um dem Druck des dort vorbeilaufenden Kühlmittels standzuhalten. Demnach ist bevorzugt, dass die erste Metallfolie und die zweite Metallfolie separat ausgeführt sind.

Die beiden Metallfolien bilden, z. B. nach Art eines Sandwich, zwischen sich einen Zwischenraum aus. Dabei ist möglich, dass der Zwischenraum allein durch die Metallfolien begrenzt ist; dies ist aber nicht zwingend erforderlich. Der Zwischenraum ist dabei bevorzugt im Wesentlichen nicht höher als die darin befindlichen Halbleiterteilchen.

Um nunmehr einen gezielten Stromfluss durch die ersten Halbleiterteilchen und die zweiten Halbleiterteilchen zu realisieren, wird vorgeschlagen, die metallischen Folien zumindest teilweise mit einer elektrischen Isolationsbeschichtung zu versehen, auf der die Halbleiterteilchen fixiert bzw. miteinander elektrisch verbunden sind. Als Isolationsbeschichtung kommt insbesondere wenigstens eine Aluminiumoxidschicht in Betracht. Die Beschichtungsdicke sollte dabei kleiner sein als die erste Materialdicke und/oder die zweite Materialdicke der Metallfolien, also z. B. kleiner als 300 µm (Mikrometer) betragen. Bei der elektrischen Isolationsbeschichtung ist darauf zu achten, dass diese den Wärmeübergang von einer Außenseite der Metallfolie hin zu den Halbleiterteilchen nicht übermäßig behindert. Dies kann insbesondere auch dadurch erreicht werden, dass die Isolationsbeschichtung tatsächlich nur im Bereich der Kontaktpunkte der Halbleiterteilchen vorgesehen ist. Jedenfalls ist eine solche elektrische Isolationsbeschichtung so dicht auszuführen, dass sie für das Verbindungsmittel, insbesondere Lot, nicht durchdringbar ist, so dass durch die Isolationsbeschichtung sicher elektrisch leitende Verbindungen hin zu der Metallfolie und/oder benachbarten Strompfaden vermieden sind.

Als leitfähige Materialien für Thermopaare von Thermoelementen, die hier mit einer Vielzahl von ersten Halbleiterteilchen und zweiten Halbleiterteilchen gebildet sind, kommen insbesondere p-dotierte und n-dotierte Halbleitermaterialien in Betracht. Hierbei könnte beispielsweise Wismut-Tellurit (Bi₂, Te₃) eingesetzt werden. Darüber hinaus könnten folgende Materialien [bei folgenden Temperaturbereichen in Kelvin] eingesetzt werden:

| | | |
|---|---|---|
| p-Typ: | CsBi₄Te₆: Sbl₃ (0,005 %) | [ca. 225 K]; |
| | ((Sb₂ Te₃)₇₂Bi₂Te₃)₂₅(Sb₂ Se₃)₃ | [ca. 300 K]; |
| | Tl₉BiTe₆ | [ca. 500 K]; |
| | GeTe₁₋ₓ(AgSbTe₂)ₓ | [ca. 700 K]; |
| n-Typ: | Bi_{0,85} Sb_{0,15} | [ca. 80 K]; |
| | (Sb₂Te₃)₅(Bi₂Te₃)₉₀(Sb₂ Se₃)₅ | [ca. 300 K]; |
| | Bi₂Te_{2,7}Se_{0,3} | [ca. 450 K]; |
| | Pb_{0,75}Sn_{0,25}Se | [ca. 800 K]. |

Bei dieser thermoelektrischen Vorrichtung werden also die zwei dünnen Metallfolien zur Begrenzung des Zwischenraums und für einen Wärmeübergang hin zu den ersten Halbleiterteilchen und zweiten Halbleiterteilchen genutzt. Die ersten Halbleiterteilchen und zweiten Halbleiterteilchen können dabei beispielsweise nach Art von kleinen Quadern und/oder kleinen länglichen Stäbchen aus unterschiedlich leitendem Material bereitgestellt und eingelötet sein. Jeweils zwei unterschiedliche Halbleiterteilchen sind so miteinander elektrisch verbunden, dass sie eine Reihenschaltung ergeben. Eine der beiden Metallfolien nimmt den einfließenden Wärmestrom auf ("Warmseite"), während die andere Metallfolie den ausfließenden Wärmestrom abgibt ("Kaltseite").

Im Hinblick auf das Design zur Anordnung bzw. Verschaltung der einzelnen ersten Halbleiterteilchen und zweiten Halbleiterteilchen können Art und/oder Gestalt und/oder Position der ersten Halbleiterteilchen und/oder zweiten Halbleiterteilchen an den Bauraum, den Wärmefluss, die Stromführung etc. angepasst sein, wobei sie sich insbesondere auch hierbei unterscheiden können. Die elektrische Verbindung der ersten Halbleiterteilchen und zweiten Halbleiterteilchen ist, zumindest für einen Teil der Halbleiterteilchen, bevorzugt abwechselnd ausgeführt - damit ist insbesondere eine Reihenschaltung der verschiedenen Halbleiterteilchen vorgesehen. Gleichwohl kann alternativ oder kumulativ auch eine Parallelschaltung realisiert sein, so dass (zumindest eine Mehrzahl) gleichartiger Halbleiterteilchen miteinander elektrisch verbunden sind.

Nach der Erfindung ist eine Ausgestaltung der thermoelektrischen Vorrichtung, bei der die erste Metallfolie eine Stahlfolie mit den Legierungsbestandteilen Chrom und Aluminium ist und eine erste Materialdicke aufweist, die im Bereich von 30 µm bis 300 µm liegt. Die hier vorgeschlagene Stahlfolie mit den Legierungsbestandteilen Chrom und Aluminium ist insbesondere hochtemperaturbeständig und korrosionsfest für Abgase, die aus mobilen Verbrennungskraftmaschinen hervorkommen. Insoweit werden hier insbesondere auch Stahlfolien vorgeschlagen, wie sie bei der Behandlung von Abgas mit metallischen Wabenkörpern eingesetzt wurden. Dabei sind beide Metallfolien mit der folgenden Zusammensetzung bevorzugt: ca. 18 - 25 Gew.-% Chrom, etwa 3 - 6 Gew.-% Aluminium, Zusätze von Titan, Yttrium und Zirkon zwischen etwa 0,04 und 0,08 Gew.-% sowie Eisen als Basis. Grundsätzlich könnte es sinnvoll sein, die erste Metallfolie mit einer ersten Materialdicke von beispielsweise bis zu 2 mm auszuführen, bevorzugt ist jedoch insbesondere auch der Bereich von 50 µm bis 300 µm. Hierbei kann gleichzeitig ein guter Wärmeübergang und andererseits eine ausreichende Stabilität für die thermoelektrische Vorrichtung bereitgestellt werden. Die zweite Materialdicke der zweiten Metallfolie kann hiervon unabhängig gewählt werden, sollte aber 2 mm ebenfalls nicht überschreiten und insbesondere größer als die erste Materialdicke sein.

Im Hinblick auf die Ausführung der ersten Metallfolie ist zudem vorgesehen, dass diese auf einer der elektrischen Isolationsbeschichtung abgewandten Außenseite eine Katalysatorträgerschicht aufweist. Das kann insbesondere dazu führen, dass die erste Metallfolie über ihre Außenseite mit den Abgasen einer Verbrennungskraftmaschine direkt in Kontakt kommt. Als Katalysatorträgerschicht kommt insbesondere eine Zeolith-Schicht und/oder so genannter Washcoat in Betracht. Zudem ist möglich, dass die Katalysatorträgerschicht tatsächlich einen Katalysator umfasst, insbesondere Edelmetalle, die in bzw. auf der Katalysatorträgerschicht verteilt angeordnet sind. Bei der Schichthöhe der Katalysatorträgerschicht ist zu berücksichtigen, dass diese den Wärmeübergang vom Abgas hin zu den Halbleiterteilchen im Zwischenraum der thermoelektrischen Vorrichtung nicht signifikant behindert. Gegebenenfalls kann dies dadurch kompensiert werden, dass exotherme Reaktionen mit dem Katalysator auf der Außenseite in Gang gesetzt werden, so dass hier vor Ort zusätzliche Wärme freigesetzt werden kann.

Gemäß einer Weiterbildung der Erfindung wird auch vorgeschlagen, dass die Vielzahl von ersten Halbleiterteilchen und zweiten Halbleiterteilchen mit Lotmaterial auf der Isolationsbeschichtung miteinander elektrisch verbunden sind. Bevorzugt ist dabei, dass die zur Fixierung der Halbleiterteilchen dienenden Lötpunkte im Wesentlichen den Querschnitt bzw. die Kontaktfläche der Halbleiterteilchen nicht überschreitet. So sind insbesondere Lotpunkte mit einer Fläche von beispielsweise zwischen 0,8 mm² bis 5 mm², und bevorzugt zwischen 1 mm² bis 2 mm² (Quadratmillimeter) zu realisieren. Das Lotmaterial wird bevorzugt dadurch aufgebracht, dass auf die Isolationsbeschichtung an den gewünschten Stellen ein Haftmittel aufgedruckt wird, und die Metallfolie mit dann pulverförmigen Lot in Kontakt gebracht wird, welches an diesen vorgegebenen Haftmittel-Stellen haften bleibt. Die Körnung des Lotmaterials ist dabei so zu wählen, dass genau so viel Lotmaterial zur Verfügung gestellt wird, dass die gewünschte Lotstelle ausgebildet wird.

Darüber hinaus wird als vorteilhaft angesehen, dass die Vielzahl von ersten Halbleiterteilchen und zweiten Halbleiterteilchen eine Teilchenhöhe von 1 mm bis 5 mm (Millimeter) aufweisen. Dies führt einerseits zu einer sehr kompakten Ausgestaltung der thermoelektrischen Vorrichtung und gewährleistet andererseits eine ausreichende Temperaturdifferenz zwischen der ersten Metallfolie und der zweiten Metallfolie über den Zwischenraum hinweg. Ganz besonders bevorzugt ist eine Teilchenhöhe im Bereich von 1 bis 2 mm. Regelmäßig werden alle Halbleiterteilchen die gleiche Teilchenhöhe aufweisen.

Außerdem wird auch vorgeschlagen, dass die erste Metallfolie und die zweite Metallfolie direkt miteinander verbunden sind. Als direkte Verbindung kommen insbesondere Löt-Verbindungen und/oder Schweiß-Verbindungen in Betracht. Ganz besonders sollte darauf geachtet werden, dass die Verbindung miteinander gasdicht ist, also insbesondere das Eindringen von Abgas und/oder Sauerstoff in den Zwischenraum vermieden wird. Gegebenenfalls können hierzu auch zusätzliche mechanische Klemmmittel und/oder Dichtungsmittel eingesetzt werden.

Gerade in diesem Zusammenhang kann auch sinnvoll sein, den Zwischenraum mit einem, die Vielzahl von ersten Halbleiterteilchen und zweiten Halbleiterteilchen zumindest teilweise umschließenden Füllstoff auszuführen. Ganz besonders bevorzugt ist, dass der Füllstoff den gesamten Zwischenraum ausfüllt. Als Füllstoff kommt beispielsweise eine Vergussmasse, wie beispielsweise Silikat, in Betracht. Auch wenn diese Variante bevorzugt ist, können gleichermaßen andere konstruktiven Maßnahmen zur Vermeidung eines Kontakts eines Abgases mit den Halbleiterteilchen verwirklicht sein, wie z. B. auch eine Kappe, ein Deckel, eine Blende oder ähnliches.

Außerdem wird auch als vorteilhaft angesehen, dass zumindest einen schichtweise Aufbau aufweist. Gegebenenfalls kann auch ein Teil der ersten Halbleiterteilchen und zweiten Halbleiterteilchen oder es könne auch alle Halbleiterteilchen schichtweise aufgebaut sein. Da hier eine besonders filigrane thermoelektrische Vorrichtung erzeugt werden kann, ist die schichtweise Applikation (z. B. mittels Aufdrucken) des Materials auf die Metallfolien besonders einfach und prozesssicher zu realisieren.

Gemäß einer Weiterbildung der Erfindung wird ein thermoelektrischer Apparat vorgeschlagen, der eine Vielzahl von thermoelektrischen Vorrichtungen der erfindungsgemäß beschriebenen Art aufweist, die nach Art eines Lagenmoduls ausgebildet sind, wobei diese jeweils entgegengesetzt zueinander angeordnet sind, so dass die ersten Metallfolien Heißkanäle und die zweiten Metallfolien Kaltkanäle begrenzen. Der thermoelektrische Apparat weist nunmehr also bevorzugt mehrere Lagen übereinander auf, wobei die Orientierung der Vorrichtungen alterniert, so dass immer paarweise erste Metallfolien Heißkanäle und zweite Metallfolien Kaltkanäle begrenzen. Im Hinblick auf die Kanäle ist möglich, dass zwischen den einzelnen Vorrichtungen nur einzelne Kanäle ausgebildet sind, es kann aber auch eine Vielzahl solcher Kanäle, beispielsweise mittels entsprechender Trennstrukturen, ausgebildet sein. Auch ist möglich, insbesondere im Hinblick auf die Kaltkanäle, dass diese mit zusätzlichen Rohren ausgeführt sind.

Ganz besonders bevorzugt wird hier ein Kraftfahrzeug mit einem Verbrennungsmotor, einer Abgasanlage, einem Wasser-Kühlkreislauf und einem thermoelektrischen Apparat der vorstehend beschriebenen Art vorgeschlagen, bei dem die Abgasanlage mit den Heißkanälen und der Wasser-Kühlkreislauf mit den Kaltkanälen verbunden sind.

Die Erfindung sowie das technische Umfeld werden nachfolgend anhand der Figuren näher erläutert. Es ist darauf hinzuweisen, dass die Figuren besonders bevorzugte Ausführungsvarianten der Erfindung aufzeigen, diese jedoch nicht darauf beschränkt ist. Es zeigen schematisch:
- Fig. 1:: ein Detail einer Ausführungsvariante einer thermoelektrischen Vorrichtung, und
- Fig. 2:: eine Ausführungsvariante eines thermoelektrischen Apparates in einem Kraftfahrzeug.

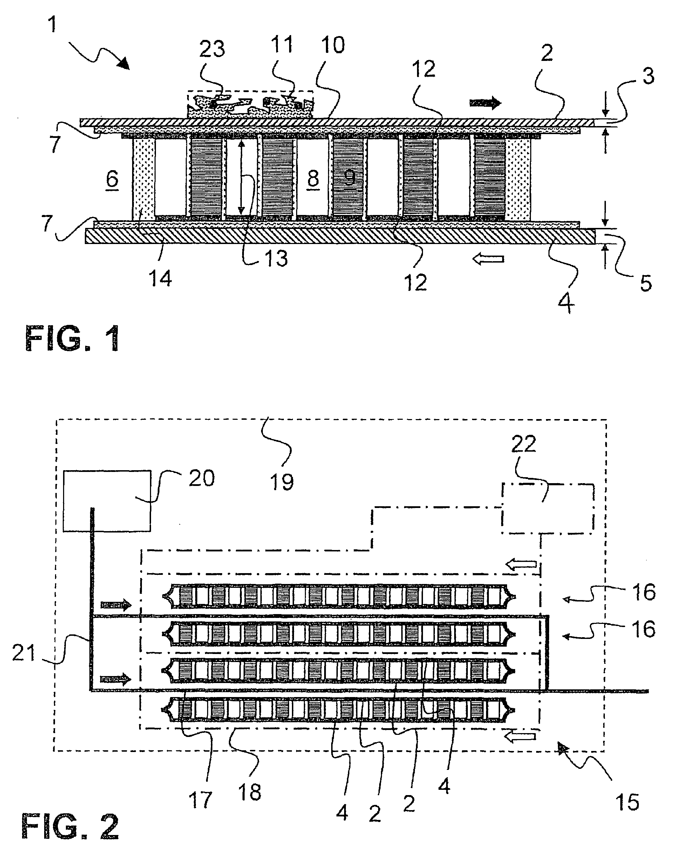

In der Fig. 1 ist schematisch in einem Teilquerschnitt eine Ausführungsvariante der thermoelektrischen Vorrichtung veranschaulicht. Die thermoelektrische Vorrichtung 1 hat oben ihre Heißseite (gekennzeichnet durch den schwarzen Pfeil) und unten ihre Kaltseite (gekennzeichnet durch einen weißen Pfeil).

Die thermoelektrische Vorrichtung 1 wird nun außen durch eine erste Metallfolie 2 und eine zweite Metallfolie 4 begrenzt. Auf der Außenseite 10 der ersten Metallfolie 2 ist in einem Ausschnitt die Katalysatorträgerschicht 11 veranschaulicht, die mit einem Katalysator 23 ausgeführt ist. Um nunmehr auf dieser Warmseite einen guten Temperaturübergang hin zum Zwischenraum 6 zu ermöglichen, ist die erste Metallfolie 2 mit einer ersten Materialdicke 3 ausgeführt, die sehr dünn ist, beispielsweise im Bereich von 50 µm bis 300 µm. Dem gegenüber ist die zweite Metallfolie hier mit einer größeren zweiten Materialdicke 5 ausgeführt, beispielsweise im Bereich von 120 µm bis 2 mm. Sowohl die erste Metallfolie 2 als auch die zweite Metallfolie 4 sind hier hin zum Innenraum 6 mit einer elektrischen Isolationsbeschichtung 7 ausgeführt.

Auf dieser elektrischen Isolationsbeschichtung 7 sind nun die Thermopaare ausgebildet. Hierfür sind die ersten (p-dotierten) Halbleiterteilchen 8 und die zweiten (n-dotierten) Halbleiterteilchen 9 mit Lotmaterial 12 auf der Isolationsbeschichtung 7 fixiert und elektrisch (in Reihe abwechselnd) miteinander verbunden. Für eine besonders kompakte Anordnung wird vorgeschlagen, dass die ersten Halbleiterteilchen 8 und die zweiten Halbleiterteilchen 9 eine Teilchenhöhe 13 von 1 mm bis 5 mm aufweisen.

In Fig. 2 soll die Integration der thermoelektrischen Vorrichtung in ein Kraftfahrzeug 19 schematisch veranschaulicht werden. In diesem Fall ist ein thermoelektrischer Apparat 15 mit einer Mehrzahl der thermoelektrischen Vorrichtung 1 derart gebildet, dass die thermoelektrische Vorrichtung 1 nach Art von Lagenmodulen 16 ausgebildet sind, die schichtweise zueinander angeordnet sind. Dabei sind die Lagenmodule 16 jeweils entgegengesetzt zueinander angeordnet, so dass die ersten Metallfolien 2 Heißkanäle 17 und die zweiten Metallfolien 4 Kaltkanäle 18 begrenzen. In Fig. 2 ist nun auch veranschaulicht, dass das in dem Verbrennungsmotor 20 erzeugte heiße Abgas entlang der Abgasanlage 21 strömt und dabei durch die Heißkanäle 17 hindurchgeführt wird. Zur Generierung eines großen Temperaturunterschiedes zwischen der Warmseite und der Kaltseite der thermoelektrischen Vorrichtung werden diese einseitig auch mit kaltem Wasser eines Wasser-Kühlkreislaufs 22 in Wärmekontakt gebracht. Der Wasser-Kühlkreislauf22 ist dabei mit den Kaltkanälen 18 verbunden, wobei das Wasser bevorzugt im Gegenstrom zum Abgas strömt.

### Bezugszeichenliste

- 1: thermoelektrische Vorrichtung
- 2: erste Metallfolie
- 3: ersten Materialdicke
- 4: zweite Metallfolie
- 5: zweite Materialdicke
- 6: Zwischenraum
- 7: Isolationsbeschichtung
- 8: erstes Halbleiterteilchen (z. B. p-dotiert)
- 9: zweites Halbleiterteilchen (z. B. n-dotiert)
- 10: Außenseite
- 11: Katalysatorträgerschicht
- 12: Lotmaterial
- 13: Teilchenhöhe
- 14: Füllstoff
- 15: thermoelektrischer Apparat
- 16: Lagenmodul
- 17: Heißkanal
- 18: Kaltkanal
- 19: Kraftfahrzeug
- 20: Verbrennungsmotor
- 21: Abgasanlage
- 22: Wasser-Kühlkreislauf
- 23: Katalysator

## Patentansprüche

1. Thermoelektrische Vorrichtung (1) aufweisend zumindest:
- eine erste Metallfolie (2) mit einer ersten Materialdicke (3),
- eine zweite Metallfolie (4) mit einer zweiten Materialdicke (5),
- einen Zwischenraum (6) zwischen der ersten Metallfolie (2) und der zweiten Metallfolie (4),
- eine elektrische Isolationsbeschichtung (7) auf der ersten Metallfolie (2) und der zweiten Metallfolie (7) hin zum Zwischenraum (6),
- eine Vielzahl von ersten Halbleiterteilchen (8) und zweiten Halbleiterteilchen (9), die im Zwischenraum (6) auf der Isolationsbeschichtung (7) fixiert und miteinander elektrisch verbunden sind,
**dadurch gekennzeichnet, dass**
die erste Metallfolie (2) eine Stahlfolie mit den Legierungsbestandteilen Chrom und Aluminium ist und eine erste Materialdicke (3) aufweist, die im Bereich von 30 µm bis 300 µm liegt und die erste Metallfolie (2) auf einer, der elektrischen Isolationsbeschichtung (7) abgewandten Außenseite (10) eine Katalysatorträgerschicht (11) aufweist.

2. Thermoelektrische Vorrichtung (1) nach Patentanspruch 1, bei der die Vielzahl von ersten Halbleiterteilchen (8) und zweiten Halbleiterteilchen (9) mit Lotmaterial (12) auf der Isolationsbeschichtung (7) miteinander elektrisch verbunden sind.

3. Thermoelektrische Vorrichtung (1) nach Patentanspruch 2, bei der die elektrische Verbindung von ersten Halbleiterteilchen (8) und zweiten Halbleiterteilchen (9) miteinander allein durch Lotmaterial (12) auf einer Isolationsbeschichtung (7) erfolgt.

4. Thermoelektrische Vorrichtung (1) nach einem der vorhergegangenen Patentansprüche, bei der die Vielzahl von ersten Halbleiterteilchen (8) und zweiten Halbleiterteilchen (9) eine Teilchenhöhe (13) von 1 bis 5 mm aufweisen.

5. Thermoelektrische Vorrichtung (1) nach einem der vorhergegangenen Patentansprüche, bei der die erste Metallfolie (2) und die zweite Metallfolie (4) direkt miteinander verbunden sind.

6. Thermoelektrische Vorrichtung (1) nach einem der vorhergegangenen Patentansprüche, bei der der Zwischenraum (6) einen die Vielzahl von ersten Halbleiterteilchen (8) und zweiten Halbleiterteilchen (9) wenigstens teilweise umschließenden Füllstoff (14) aufweist.

7. Thermoelektrische Vorrichtung (1) nach einem der vorhergegangenen Patentansprüche, bei der zumindest ein Teil der ersten Halbleiterteilchen (8) oder zweiten Halbleiterteilchen (9) einen schichtweise Aufbau aufweist.

8. Thermoelektrischer Apparat (15), aufweisend eine Vielzahl von thermoelektrische Vorrichtungen (1) gemäß einem der vorhergehenden Patentansprüche nach Art eines Lagenmoduls (16), die jeweils entgegengesetzt zu einander angeordnet sind, wobei die ersten Metallfolien (2) Heißkanäle (17) und die zweiten Metallfolien (4) Kaltkanäle (18) begrenzen.

9. Kraftfahrzeug (19) mit einem Verbrennungsmotor (20), einer Abgasanlage (21), einem Wasser-Kühlkreislauf (22) und einem thermoelektrischen Apparat (15) gemäß Patentanspruch 8, bei dem die Abgasanlage (21) mit den Heißkanälen (17) und der Wasser-Kühlkreislauf (22) mit den Kaltkanälen (18) verbunden sind.

## Claims

1. Thermoelectric device (1) comprising at least:
- a first metal foil (2) having a first material thickness (3),
- a second metal foil (4) having a second material thickness (5),
- an interspace (6) between the first metal foil (2) and the second metal foil (4),
- an electrical insulation coating (7) on the first metal foil (2) and the second metal foil (7) toward the interspace (6), and
- a multiplicity of first semiconductor components (8) and second semiconductor components (9), which are fixed and electrically connected to one another on the insulation coating (7) in the interspace (6),
**characterized in that**
the first metal foil (2) is a steel foil comprising the alloying constituents chromium and aluminium and has a first material thickness (3), which is in the range of 30 µm to 300 µm, and the first metal foil (2) has a catalyst support layer (11) on an outer side (10) facing away from the electrical insulating coating (7).

2. Thermoelectric device (1) as claimed in claim 1, wherein the multiplicity of first semiconductor components (8) and second semiconductor components (9) are electrically connected to one another by means of solder material (12) on the insulation coating (7).

3. Thermoelectric device (1) as claimed in claim 2, wherein the electrical connection of first semiconductor components (8) and second semiconductor components (9) to one another is done only by means of solder material (12) on the insulation coating (7)

4. Thermoelectric device (1) as claimed in any of the preceding patent claims, wherein the multiplicity of first semiconductor components (8) and second semiconductor components (9) have a component height (13) of 1 to 5 mm.

5. Thermoelectric device (1) as claimed in any of the preceding patent claims, wherein the first metal foil (2) and the second metal foil (4) are directly connected to one another.

6. Thermoelectric device (1) as claimed in any of the preceding patent claims, wherein the interspace (6) has a filler medium (14) that at least partly encloses the multiplicity of first semiconductor components (8) and second semiconductor components (9).

7. Thermoelectric device (1) as claimed in any of the preceding patent claims, wherein at least a portion of the first semiconductor components (8) or second semiconductor components (9) has a layered construction.

8. Thermoelectric apparatus (15), comprising a multiplicity of thermoelectric devices (1) as claimed in any of the preceding patent claims in the manner of a layer module (16), which are arranged respectively oppositely relative to one another, wherein the first metal foils (2) delimit hot channels (17) and the second metal foils (4) delimit cold channels (18).

9. Motor vehicle (19) comprising an internal combustion engine (20) an exhaust gas system (21), a water cooling circuit (22) and a thermoelectric apparatus (15) as claimed in patent claim 8, wherein the exhaust gas system (21) is connected to the hot channels (17) and the water cooling circuit (22) is connected to the cold channels (18).

## Revendications

1. Dispositif thermoélectrique (1) comprenant au moins:
- une première feuille métallique (2) avec une première épaisseur de matière (3),
- une deuxième feuille métallique (4) avec une deuxième épaisseur de matière (5),
- un espace intermédiaire (6) entre la première feuille métallique (2) et la deuxième feuille métallique (4),
- un revêtement d'isolation électrique (7) sur la première feuille métallique (2) et la deuxième feuille métallique (4) du côté de l'espace intermédiaire (6),
- une multiplicité de premières particules semi-conductrices (8) et de deuxièmes particules semi-conductrices (9), qui sont fixées sur le revêtement d'isolation électrique (7) dans l'espace intermédiaire (6) et qui sont électriquement reliées entre elles,
**caractérisé en ce que** la première feuille métallique (2) est une feuille d'acier avec les composants d'alliage chrome et aluminium et présente une première épaisseur de matière (3), qui se situe dans la gamme de 30 µm à 300 µm et la première feuille métallique (2) présente une couche de support de catalyseur (11) sur une face extérieure (10) opposée au revêtement d'isolation électrique (7).

2. Dispositif thermoélectrique (1) selon la revendication 1, dans lequel la multiplicité de premières particules semi-conductrices (8) et de deuxièmes particules semi-conductrices (9) sont électriquement reliées entre elles avec une matière de brasage (12) sur le revêtement d'isolation électrique (7).

3. Dispositif thermoélectrique (1) selon la revendication 2, dans lequel la liaison électrique de premières particules semi-conductrices (8) et de deuxièmes particules semi-conductrices (9) entre elles est réalisée uniquement par une matière de brasage (12) sur un revêtement d'isolation électrique (7).

4. Dispositif thermoélectrique (1) selon l'une quelconque des revendications précédentes, dans lequel la multiplicité de premières particules semi-conductrices (8) et de deuxièmes particules semi-conductrices (9) présentent une hauteur de particules (13) de 1 à 5 mm.

5. Dispositif thermoélectrique (1) selon l'une quelconque des revendications précédentes, dans lequel la première feuille métallique (2) et la deuxième feuille métallique (4) sont reliées directement l'une à l'autre.

6. Dispositif thermoélectrique (1) selon l'une quelconque des revendications précédentes, dans lequel l'espace intermédiaire (6) présente une matière de remplissage (14) entourant au moins partiellement la multiplicité de premières particules semi-conductrices (8) et de deuxièmes particules semi-conductrices (9).

7. Dispositif thermoélectrique (1) selon l'une quelconque des revendications précédentes, dans lequel au moins une partie des premières particules semi-conductrices (8) ou des deuxièmes particules semi-conductrices (9) présente une structure stratifiée.

8. Appareil thermoélectrique (15), comportant une multiplicité de dispositifs thermoélectriques (1) selon l'une quelconque des revendications précédentes à la manière d'un module de couches (16), qui sont disposés respectivement en opposition l'un à l'autre, dans lequel les premières feuilles métalliques (2) délimitent des canaux de chauffage (17) et les deuxièmes feuilles métalliques (4) délimitent des canaux de refroidissement (18).

9. Véhicule automobile (19) avec un moteur à combustion interne (20), une installation de gaz d'échappement (21), un circuit d'eau de refroidissement (22) et un appareil thermoélectrique (15) selon la revendication 8, dans lequel l'installation de gaz d'échappement (21) est raccordée aux canaux de chauffage (17) et le circuit d'eau de refroidissement (22) est raccordé aux canaux de refroidissement (18).
